Europäisches Patentamt

European Patent Office

Office européen des brevets

(19)

(11) Publication number: **0 238 286 B1**

(12) # EUROPEAN PATENT SPECIFICATION

(45) Date of publication of patent specification: **10.06.92** (51) Int. Cl.5: **H03G 3/20**

(21) Application number: **87302230.5**

(22) Date of filing: **16.03.87**

(54) **Automatic gain control apparatus.**

(30) Priority: **18.03.86 JP 58303/86**

(43) Date of publication of application:
**23.09.87 Bulletin 87/39**

(45) Publication of the grant of the patent:
**10.06.92 Bulletin 92/24**

(84) Designated Contracting States:
**DE FR GB**

(56) References cited:
**FR-A- 2 129 053**
**US-A- 3 579 138**
**US-A- 3 931 584**
**US-A- 4 070 632**

(73) Proprietor: **NEC CORPORATION**
**7-1, Shiba 5-chome Minato-ku**
**Tokyo 108-01(JP)**

(72) Inventor: **Hara, Toshihiro c/o NEC Corporation**
**7-1, Shiba 5-chome**
**Minato-ku Tokyo(JP)**

(74) Representative: **Orchard, Oliver John**
**JOHN ORCHARD & CO. Staple Inn Buildings**
**North High Holborn**
**London WC1V 7PZ(GB)**

Rank Xerox (UK) Business Services

EP 0 238 286 B1

## Description

Background of the Invention

The present invention relates to an automatic gain control apparatus for use in a receiver of radio communication system or the like, and more particularly to an automatic gain control apparatus using digital control technique.

An automatic gain control apparatus, extensively used in a receiver of radio communication system or the like, is intended for control to keep received signals, which have undergone amplitude variation by fading or some other cause on the radio transmission line, at a constant amplitude. Many of recent such control apparatuses use digital, instead of analog, control technique. An automatic gain control apparatus using such digital control technique is mainly composed of an automatic gain controlled (AGC) circuit (or AGC amplifier), analog/digital (A/D) converter, a digital AGC controller and a digital/analog (D/A) converter. In this apparatus, the output of the AGC circuit is converted by the A/D converter into a digital signal, then by the digital AGC controller into a digital control signal, and further by the D/A converter into an analog control signal, which is supplied to the AGC circuit. The AGC circuit varies its gain in response to the analog control signal, and achieves control to maintain the output of the AGC circuit at a constant amplitude.

In such an automatic gain control apparatus, as will be described in detail hereinafter, if the numbers of bits in the A/D converter and the D/A converter are small and the output amplitude variability of the AGC circuit is great, the output amplitude control by the AGC circuit will be rough, and the output of the AGC circuit will fail to be constant, resulting in amplitude modulated signals. On the other hand, if the output amplitude is to be finely controlled, the aforementioned converters will have to be able to handle greater numbers of bits, which would mean higher costs of the converters and a more complex composition of the digital AGC controller. Moreover, this would also entail finer increment and decrement of the control for digital control signals in the digital AGC controller, resulting in the disadvantage that the controller would be unable to follow abrupt variations in input amplitude caused by fading or some other factor.

In the specification of the French patent published under the number 2,129,053 on October 27 1972, there is proposed an automatic gain control system in which a first control signal is generated in response to a gain controlled signal and a second control signal is a time varied signal which does not depend on an input signal.

In an embodiment of the invention to be described there are provided rectifier means for converting the level of a received signal into a D.C. voltage; comparing means for converting the D.C. voltage into a first control signal; voltage generating means responsive to the first control signal and a second control signal for generating an automatic gain control voltage; AGC circuit means responsive to the automatic gain control voltage for controlling the amplitude of said received signal; detector means for envelope-detecting the output of the AGC circuit means; analog/digital converter means for converting the output of the detector means into a digital signal; digital AGC controller means for digitally processing the output of the analog/digital converter means; and digital/analog converter means for converting the output of said AGC controller means into an analog signal and supplying said second control signal.

Brief Description of Drawings

Fig. 1 is a block diagram illustrating a radio receiver using an automatic gain control apparatus by the prior art;

Figs. 2A and 2B are charts for explaining the operation of the receiver shown in Fig. 1;

Fig. 3 is a block diagram of an automatic gain control apparatus which is a preferred embodiment of the present invention;

Fig. 4 is a circuit diagram illustrating an embodiment of the comparing circuit shown in Fig. 3;

Fig. 5 is a table showing the state of output corresponding to a given voltage in the circuit of Fig. 2;

Fig. 6 is a circuit diagram illustrating an embodiment of the voltage generating circuit shown in Fig. 3;

Fig. 7 is a chart for explaining the operation of the circuit of Fig. 6; and

Fig. 8 is a circuit diagram illustrating an embodiment of the AGC circuit in Fig. 3.

Detailed Description of the Invention

Referring to Fig. I illustrating a radio receiver using an automatic gain control apparatus by the prior art, an RF signal, for instance an FM signal, is picked up by an antenna II0, amplified by an RF amplifier III, then converted into an IF signal by a frequency converter II2, level-controlled by an automatic gain control apparatus I00, and demodulated by a demodulator II3.

In the automatic gain control apparatus I00, a signal which has undergone fading on the radio transmission path is supplied to an AGC circuit I0I. This AGC circuit I0I is so structured as to achieve current-conversion of a voltage supplied from a D/A converter I02 and be controlled by a variable gain element for current control. The output of the AGC circuit l0l is AM (envelope) detected by a detector l05, and entered into an A/D converter l03. Reference numeral l04 represents a digital AGC controller which uses the output of this A/D converter l03 as its input, and supplies its output to the D/A converter l02.

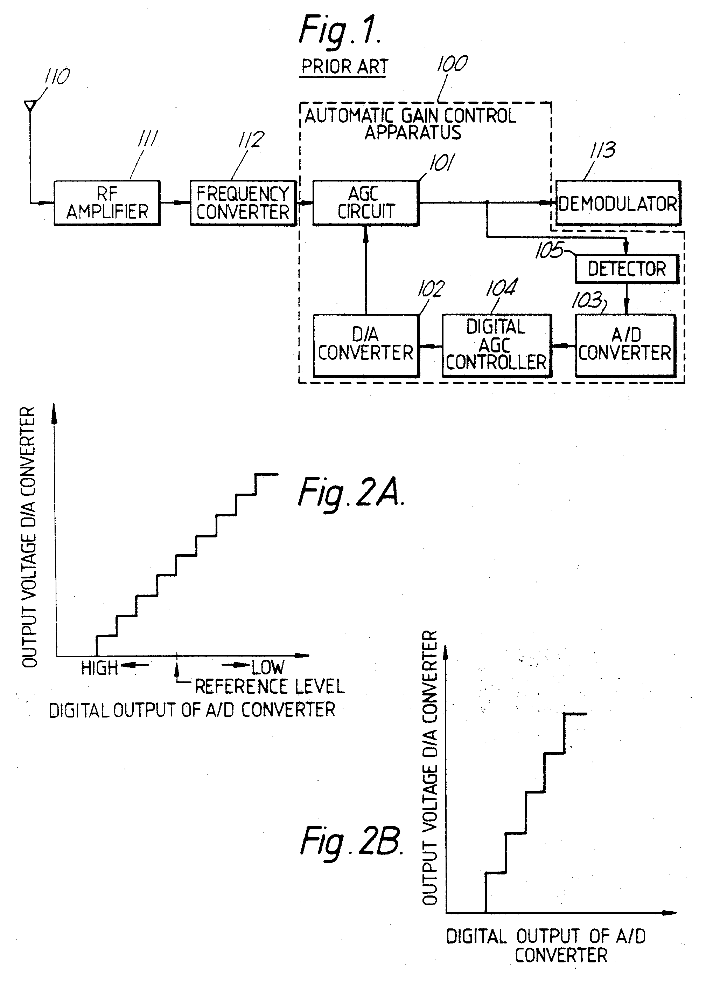

The operation of an automatic gain control apparatus structured in this manner will be described below with reference to Figs. 2A and 2B.
In Fig. 2A, the digital output of the A/C converter l03 is represented on the axis of abscissas, and the output voltage V of the D/A converter l02, on the axis of ordinates.

The AGC controller l04 so effects control that the output of the AGC circuit l0l remain constant in amplitude. This digital AGC controller l04 has a reference level as shown in Fig. 2A. If the output signal level of the AGC circuit 101, entered from the output end of the A/D converter l03, is below the reference level, the digital AGC controller l04, as shown in Fig. 2A, will so control the increment of a counter in the digital AGC controller l04 as to raise the output voltage of the D/A converter l02. If it is above the reference level, the digital AGC controller l04 will so control the decrement of the counter as to lower the output voltage of the D/A converter l02, so that the output level of the AGC circuit l0l be kept constant.

Where it is desired to finely control the output signal, the number of bits handled by the D/A converter l02 is increased.

In the above described automatic gain control apparatus using conventional digital control, a D/A converter is used for voltage control, so that the output voltage of the D/A converter varies stepwise, as shown in Fig. 2A.

If the number of bits inputted to the D/A converter l02 is relatively small and the variable range of its output voltage is widened, the output voltage will greatly vary per bit of variation, so that the control by the AGC circuit l0l will become rough, resulting in an unconstant output of the AGC circuit l0l, somewhat like an amplitude-modulated signal. Consequently, if the number of bits handled by the D/A converter is increased to finely adjust the amplitude, the digital AGC controller will become unable to follow the velocity of fading or any abrupt variation as its counter is too slow in increment or decrement.

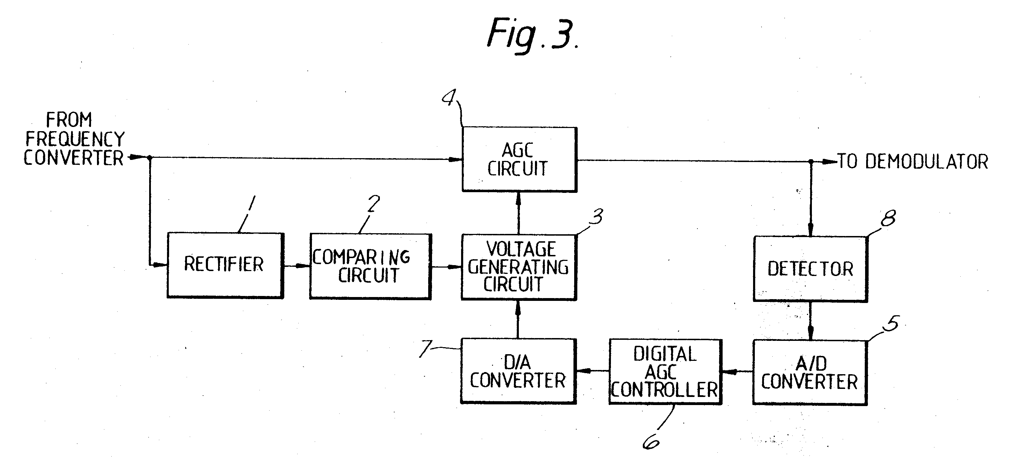

Fig. 3 is a block diagram illustrating an automatic gain control apparatus which is a preferred embodiment of the present invention.

In the figure, a rectifier l converts the level of the received signal into a D.C. voltage. A comparing circuit or A/D converter 2 converts the output of the rectifier l into control digital signals. A voltage generating circuit 3 is for generating an AGC voltage according to the output signal of this comparing circuit 2 and the output voltage of a D/A converter 2. An AGC circuit 4 converts the output voltage of this voltage generating circuit 3 into a current and controlling the amplitude of said received signal. An A/D converter 5 is for converting the output signal of this AGC circuit 4 into a digital signal. A digital AGC controller 6 compares the output signal of this A/D converter 5 with its own reference level, and so achieves control as to reduce the output voltage of a D/A converter 7 if the former is higher than the latter or to raise it if the former is lower. The D/A converter 7 is so structured as to convert the output signal of the digital AGC circuit 6 into an analog voltage, which is supplied to the voltage generating circuit 3. A detector 8 is for AM-detecting the output of the AGC circuit l0l. These circuits 4, 5, 6, 7 and 8 respectively correspond to the circuits l0l, l03, l04, l02 and l05 of the apparatus illustrated in Fig. l.

Next will be described the operation of the preferred embodiment illustrated in this Fig. 3.

First, an IF signal, whose amplitude is varied by fading on the radio transmission path, is supplied to the rectifier l and the AGC circuit 4. The rectifier l is a circuit for converting the level of the signal received over the radio transmission path into a D.C. voltage level signal, and its output is supplied to the comparing circuit 2. The comparing circuit 2 is intended for determining the reception level after conversion into the D.C. voltage signal by the rectifier l, and it supplies the voltage generating circuit 3 with a signal corresponding to the reception level.

Then, the voltage generating circuit 3, intended for generating a voltage to control the variable gain element of the AGC circuit 4, generates an AGC voltage according to a signal from the comparing circuit 2 and another from the D/A converter 7. The AGC circuit 4, a circuit for controlling the variable gain element by varying the current, receives the input of an IF signal with a variable amplitude level, and controls its amplitude. The A/D converter 5 is a circuit for converting the output signal of the AGC circuit 4, AM-detected by the detector 8, into a digital signal.

Now, the AGC controller 6 determines whether the amplitude of the digital signal inputted from the A/D converter 5 is above or below the reference level by digital signal processing. If above, the controller 6 will decrement the count, or if below, it will increment the count, to control the AGC circuit 4 through the D/A converter 7 and the voltage generating circuit 3. The D/A converter 7 is intended for converting the output digital signal of the AGC controller 6 into an analog voltage signal.

Now will be described the specific compositions of the main constituent elements of the above mentioned automatic gain control apparatus and how they operate.

First, the rectifier I can be composed of an ordinary full-wave rectifier circuit and a smoothing circuit, and may be an full-wave rectifier circuit having a log characteristic if it is to rectify receive field signals. It converts variations in received signals into D.C. voltage signals.

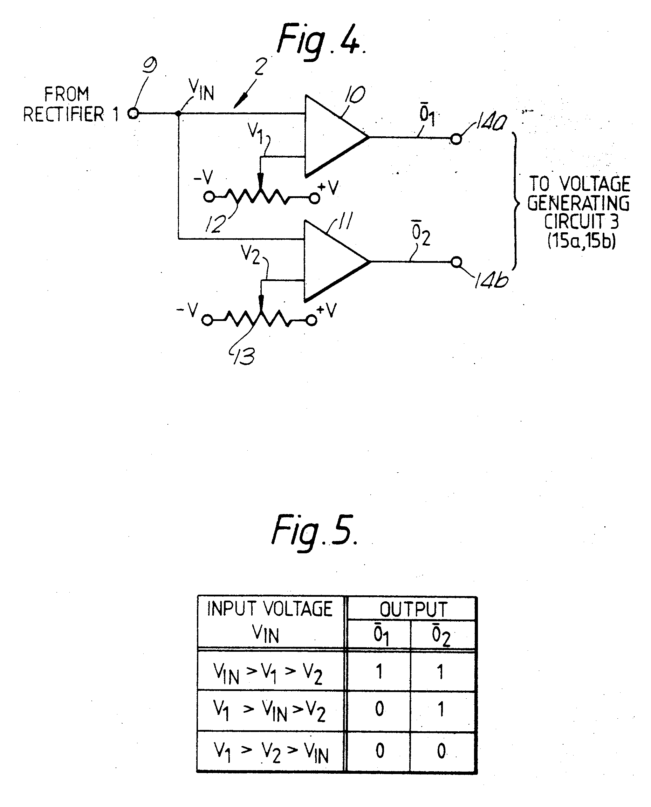

Next, the comparing circuit 2 is structured as shown in Fig. 4. In this Fig. 4 illustrating an embodiment of the comparing circuit 2, reference numeral 9 represents a terminal to which a D.C. voltage signal from the rectifier I is to be inputted, and the D.C. voltage $V_{IN}$ fed to this terminal is supplied to one each of the input terminals of comparators I0 and II to undergo level determination.

In these comparators I0 and II are set determination levels for voltages $V_1$ and $V_2$, obtained by resistors I2 and I3 connected to $+V$ and $-V$ voltage terminals. As shown in Fig. 5 for explaining the operation, the comparator circuit 2 so operates as to make output $\overline{O_1}$ and $\overline{O_2}$ of the comparators I0 and II both "I" in logical level when the input D.C. voltage $V_{IN}$ is greater than voltages $V_1$ and $V_2$; their outputs $\overline{O_1}$ and $\overline{O_2}$ "I" and "0", respectively, when the input D.C. voltage $V_{IN}$ is below voltage $V_1$ and above $V_2$; and their outputs $\overline{O_1}$ and $\overline{O_2}$ both "0" when the input D.C. voltage $V_{IN}$ is below voltages $V_1$ and $V_2$, and indicates in two-bit binary signals how the input signal level varies. In this Fig. 4, reference numerals I4a and I4b represent output terminals.

Incidentally, though the embodiment shown in Fig. 4 uses two comparators, I0 and II, a larger number of comparators can be used to achieve finer determination of levels if signal variations are to be assessed in greater detail.

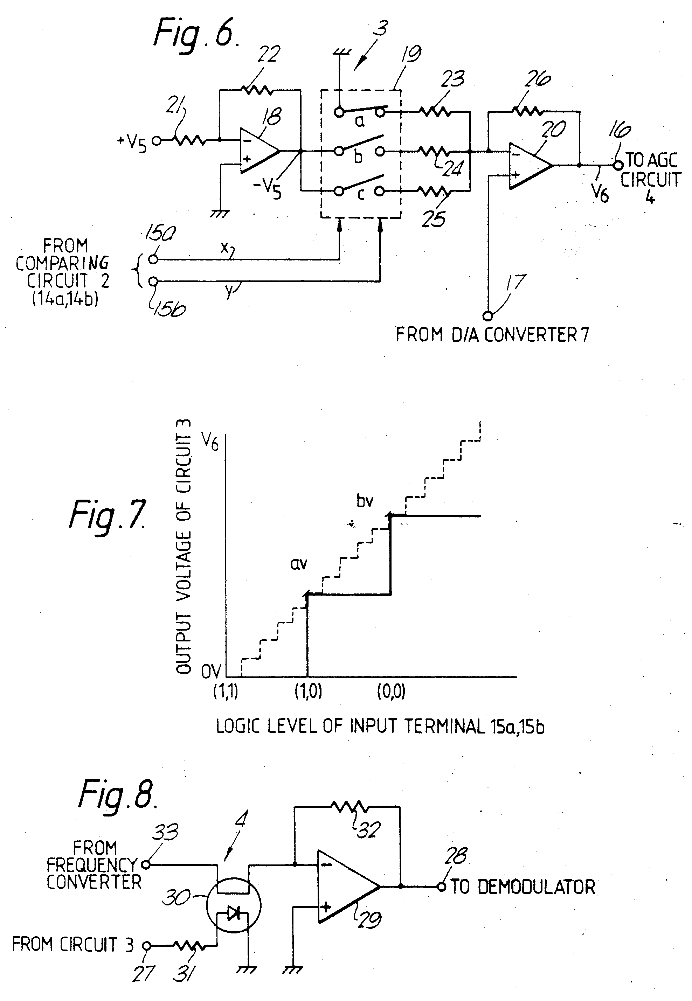

Now, the voltage generating circuit 3 is structured as shown in Fig. 6. In Fig. 6, reference numerals I5a and I5b represent input terminals to which the outputs from the output terminals I4a and I4b of the comparing circuit 2, shown in Fig. 4, are supplied; I6 represents an output terminal, and I7, a terminal to which the voltage from the D/A converter 7 is inputted. An operational amplifier I8 inverts and amplifies a reference voltage $+V_5$ to provide a negative reference voltage $-V_5$.

This voltage $-V_5$ is inputted to a switch I9, which is opened and closed by signals x and y from the input terminals I5a and I5b. When the signals x and y are both "I" in logic level, the switch I9 closes a switch a to connect the ground and a resistor 23. The resistor 23 here has a high resistance, as high as that of a resistor 26. If the input voltage from the terminal I7 is 0 V, an output voltage $V_6$ obtained at the output terminal I6 of the operational amplifier 20 will be 0 V as shown in Fig. 7.

Then, if the logic levels of the signals x and y are "I" and "0", respectively, the switch I9 will close a switch b to connect the voltage $-V_5$ at the output end of the operational I8 and a resistor 24. The resistor 24 here has a resistance lower than the resistor 23, and voltage $-V_5$ is amplified by as much as the gain between resistors 26 and 24 to $a_V$, as shown in Fig. 7, by the operational amplifier (inverting amplifier) 20.

Next, if the logic levels of the signals x and y are both "0", the switch I9 will close a switch c to connect voltage $-V_5$ at the output end of the operational amplifier I8 and a resistor 25. This resistor 25 has a lower resistance than the resistor 24, and voltage $-V_5$ is amplified by as much as the gain between resistors 26 and 25 to $b_V$, as shown in Fig. 7, by the operational amplifier 20.

As is evident from Fig. 7, the output voltage of the voltage generating circuit 3 illustrated in Fig. 6 is varied stepwise, as shown in Fig 7, by the outputs from the output terminals I4a and I4b of the comparing circuit 2 illustrated in Fig. 4.

Meanwhile, since the voltage from the D/A converter 7 supplied through the terminal I7 is entered into the non-inverted input of the operational amplifier I8, it is added to the aforementioned voltage which varies stepwise to give the other voltage shown in a dotted line.

As a result, the range of voltage variation by the D/A converter 7 need not be greater than a single step of the solid line in Fig. 7.

In Fig. 8 showing an embodiment of the AGC circuit 4, the same signs as in Fig. I represent respectively corresponding elements, reference numeral 27 representing an input terminal to which a control voltage is supplied from the circuit 3 (Fig. 3); 28, an output terminal from which an output is supplied to the detector 8 and the demodulator II3 (Fig. 2); and 33, an input terminal to which an IF signal is supplied from the frequency converter II2 (Fig. 2).

The AGC circuit 4 comprises an operational amplifier 29, a current-controlled variable gain element 30, and resistors 3I and 32.

The control voltage supplied to the input terminal 27 is converted into a current by the resistor 3I to control the variable gain element 30. The variable gain element 30 here has a characteristic that its resistance is low when its current is high and vice versa. The current-controlled variable gain element 30 controls the IF signal amplitude supplied to the terminal 33.

Then, the A/D converter 5 and D/A converter 7 may consist of an ordinary A/D converter and D/A converter, respectively. The A/D converter 5 converts the output signal of the AGC circuit 4 into a digital signal, while the D/A converter 7 converts the digital signal from the digital AGC controller 6 into an analog voltage.

Next, the digital AGC controller 6, which may consist of an ordinary digital signal processor, will so achieve control as to reduce the output voltage of D/A converter 7 if the amplitude of the digital signal from the A/D converter 5 is above the reference level or to raise the output voltage of the D/A converter 7 if it is below the reference level.

As hitherto described, the present invention has tremendous benefits in practical application because it effects automatic gain control according to information on the level variation of input signals, so that fine control can be accomplished without having to increase the number of bits in the D/A converter, a wide enough dynamic range can be secured and abrupt variations in input signal level can be effectively coped with. An automatic gain control apparatus hereunder also is highly useful in that it can readily follow sharp changes, such as fading, and accomplish fine amplitude control without having to increase the number of bits in the D/A converter.

## Claims

1. An automatic gain control apparatus for receiving a signal, the apparatus including a voltage generating circuit (3) providing a gain control signal and responsive to a first control signal and a second control signal for generating an automatic gain control signal, an AGC circuit (4) responsive to the automatic gain control signal for controlling the amplitude of the received signal, a detector (8) for detecting an output of the AGC circuit to produce an output of the detector (8), an analog/digital converter (5) for converting the output of the detector (8) into a digital signal, a digital AGC controller (6) responsive to the digital signal for generating a digitally processed signal, and a digital/analog converter (7) for converting the digitally processed signal into the second control signal, characterised in that the digital AGC controller (6) increments and decrements a count depending upon a difference between the digital signal and a reference level and outputs the count as the digitally processed signal, and in that the apparatus further includes a rectifier (1) for converting the level of the received signal into a DC value and a comparing circuit (2) responsive to both the DC value and a second referance level for generating the first control signal.

2. An automatic gain control apparatus as claimed in claim 1, characterised in that the voltage generating circuit (3) includes means (18, 19, 21, 22, 23, 24, 25) for converting a reference D.C. value (+V5) into one of a plurality of D.C. values in response to the first control signal (x, y), and means (20, 26) for combining the second control signal (17) with the one of the plurality of D.C. values, thereby providing the automatic gain control signal (16).

3. An automatic gain control apparatus as claimed in claim 2, characterised in that the rectifier means (1) is a full-wave rectifier.

## Revendications

1. Dispositif de commande automatique de gain pour recevoir un signal, le dispositif comportant un circuit de génération de tension (3) délivrant un signal de commande de gain et sensible à un premier signal de commande et à un second signal de commande pour produire un signal de commande automatique de gain, un circuit à gain automatique commandé (4) sensible au signal de commande automatique de gain pour commander l'amplitude du signal reçu, un détecteur (8) pour détecter une sortie du circuit à gain automatique commandé pour produire une sortie du détecteur (8), un convertisseur analogique/numérique (5) pour convertir la sortie du détecteur (8) en un signal numérique, un contrôleur numérique à gain automatique commandé (6) sensible au signal numérique pour produire un signal numériquement traité et un convertisseur numérique/analogique (7) pour convertir le signal numériquement traité en le second signal de commande, caractérisé en ce que le contrôleur numérique à gain automatique commandé (6) incrémente et décrémente un compteur fonction d'une différence entre le signal numérique et un niveau de référence et sort le compte comme le signal numériquement traité et en ce que le dispositif comprend de plus un redresseur (1) pour convertir le niveau du signal reçu en une valeur à courant continu et un circuit de comparaison (2) sensible à la fois à la valeur du courant continu et à un second niveau de référence pour produire le premier signal de commande.

2. Dispositif de commande automatique de gain selon la revendication 1, caractérisé en ce que le circuit de génération de tension (3) comporte des moyens (18, 19, 21, 22, 23, 24, 25) pour convertir une valeur de courant continu de référence (+VS) en une valeur d'une multitude de valeurs à courant continu en réponse au premier signal de commande (x, y) et des moyens (20, 26) pour combiner le second signal de commande (17) avec la valeur de la multitude des valeurs à courant continu, délivrant de ce fait le signal de commande automatique de gain (16).

3. Dispositif de commande automatique de gain selon la revendication 2, caractérisé en ce que le moyen de redresseur (1) est un redresseur à double alternance.

**Patentansprüche**

1. Schaltungsanordnung zur automatischen Verstärkungsregelung eines Empfangssignals, die folgende Bestandteile aufweist: einen Spannungsgenerator (3) zum Erzeugen eines Verstärkungssteuersignals und zum Erzeugen eines Automatikverstärkungssteuersignals in Abhängigkeit von einem ersten und einem zweiten Steuersignal, einem AGC-Schaltkreis (4), das auf das Automatikverstärkungssteuersignal anspricht, um die Amplitude des Empfangssignals zu steuern, einem Detektor (8) zum Detektieren eines Ausgangssignals des AGC-Schaltkreises und Erzeugen eines Ausgangssignals des Detektors (8), einen Analog/Digital-Umsetzers (5) zum Umsetzen des Ausgangssignals des Detektors (8) in ein Digitalsignal, einen digitalen AGC-Steuerschaltkreis (6), der auf das Digitalsignal anspricht, um ein digital verarbeitetes Signal zu erzeugen, und einen Digital/Analog-Umsetzer (7) zum Umsetzen des digital verarbeiteten Signals in das zweite Steuersignal, **dadurch gekennzeichnet,** daß der digitale AGC-Steuerschaltkreis (6) einen Zählwert erhöht und erniedrigt in Abhängigkeit von der Differenz zwischen dem Digitalsignal und einem Referenzwert sowie den Zählwert als digital verarbeitetes Signal ausgibt, und daß ein Gleichrichter (1) vorgesehen ist, um den Pegel des Empfangssignals in einem Gleichstromwert umzuwandeln, sowie ein Vergleicherschaltkreis (2) vorgesehen ist, der sowohl auf den Gleichstromwert als auch auf einen zweiten Bezugswert anspricht, um das erste Steuersignal zu erzeugen.

2. Schaltungsanordnung zur automatischen Verstärkungsregelung nach Anspruch 1, **dadurch gekennzeichnet,** daß der Spannungsgenerator (3) Einrichtungen (18, 19, 21, 22, 23, 24, 25) zum Umwandeln eines Bezugsgleichspannungswerts (+V5) in einen oder mehrere Gleichspannungswerte aufgrund des ersten Steuersignals (x, y) sowie eine Einrichtung (20, 26) zum Kombinieren des zweiten Steuersignals (17) mit dem einen aus den mehreren Gleichspannungswerten aufweist, um das Automatikverstärkungssteuersignal (16) zu erzeugen.

3. Schaltungsanordnung zur automatischen Verstärkungsregelung nach Anspruch 2, **dadurch gekennzeichnet,** daß der Gleichrichter (1) ein Zweiweg-Gleichrichter ist.

# Fig.1.

## PRIOR ART

110

111 RF AMPLIFIER

112 FREQUENCY CONVERTER

100

### AUTOMATIC GAIN CONTROL APPARATUS

101 AGC CIRCUIT

113 DEMODULATOR

105 DETECTOR

102 D/A CONVERTER

104 DIGITAL AGC CONTROLLER

103 A/D CONVERTER

# Fig.2A.

OUTPUT VOLTAGE D/A CONVERTER

HIGH ← → LOW
REFERENCE LEVEL
DIGITAL OUTPUT OF A/D CONVERTER

# Fig.2B.

OUTPUT VOLTAGE D/A CONVERTER

DIGITAL OUTPUT OF A/D CONVERTER

7

**Fig.3.**

FROM FREQUENCY CONVERTER → ... → AGC CIRCUIT (4) → TO DEMODULATOR

RECTIFIER (1) → COMPARING CIRCUIT (2) → VOLTAGE GENERATING CIRCUIT (3)

DETECTOR (8)

D/A CONVERTER (7) ← DIGITAL AGC CONTROLLER (6) ← A/D CONVERTER (5)

EP 0 238 286 B1

# Fig.4.

FROM
RECTIFIER 1

$V_{IN}$

$V_1$

$V_2$

$\bar{0}_1$

$\bar{0}_2$

14a

14b

12

13

-V    +V

-V    +V

TO VOLTAGE
GENERATING
CIRCUIT 3
(15a,15b)

# Fig.5.

| INPUT VOLTAGE $V_{IN}$ | OUTPUT | |
|---|---|---|
| | $\bar{0}_1$ | $\bar{0}_2$ |
| $V_{IN} > V_1 > V_2$ | 1 | 1 |
| $V_1 > V_{IN} > V_2$ | 0 | 1 |
| $V_1 > V_2 > V_{IN}$ | 0 | 0 |

9

EP 0 238 286 B1

Fig. 6.

+V5

FROM
COMPARING
CIRCUIT 2
(14a,14b)

x

y

FROM D/A CONVERTER 7

TO AGC
CIRCUIT
4

V6

Fig. 7.

OUTPUT VOLTAGE OF CIRCUIT 3

V6

bv

av

0V

(1,1)　　(1,0)　　(0,0)

LOGIC LEVEL OF INPUT TERMINAL 15a,15b

Fig. 8.

FROM
FREQUENCY
CONVERTER

FROM CIRCUIT 3

TO DEMODULATOR

10